# EUROPÄISCHE PATENTSCHRIFT

(11) **EP 0 931 342 B1**
(45) Veröffentlichungstag und Bekanntmachung des Hinweises auf die Patenterteilung: **21.01.2004**
(21) Anmeldenummer: 97909130.3
(22) Anmeldetag: 11.09.1997
(51) Int. Cl.: H01L 21/8247, H01L 27/115, H01L 21/8242, H01L 27/108, H01L 21/3205

(54) **EINE BARRIERENFREIE HALBLEITERSPEICHERANORDNUNGEN UND DEREN HERSTELLUNGSVERFAHREN**
A BARRIER-FREE SEMICONDUCTOR STORAGE ASSEMBLY AND PROCESS FOR ITS PRODUCTION
ENSEMBLE MEMOIRE A SEMICONDUCTEUR SANS COUCHES D'ARRET ET SON PROCEDE DE FABRICATION

(30) Priorität: 30.09.1996 DE 19640413
(43) Veröffentlichungstag der Anmeldung: 28.07.1999
(73) Patentinhaber: Infineon Technologies AG, 81669 München (DE)
(72) Erfinder: HINTERMAIER, Frank, D-81373 München (DE); MAZURE-ESPEJO, Carlos, D-85604 Zorneding (DE)
(74) Vertreter: Epping, Hermann, Fischer
(86) Internationale Anmeldenummer: PCT/DE1997/002033
(87) Internationale Veröffentlichungsnummer: WO 1998/015003

(56) Entgegenhaltungen:
- US-A- 5 313 089
- US-A- 5 436 477

## Beschreibung

Die Erfindung betrifft ein Verfahren zu Herstellung einer integrierten Halbleiterspeicheranordnung und eine nach dem Verfahren hergestellte Halbleiterspeicheranordnung.

Speicheranordnungen auf Halbleiterbasis bestehen üblicherweise aus einer Anzahl Speicherzellen, die jeweils einen Auswahltransistor und einen mit dem Auswahltransistor verbundenen Speicherkondensator aufweisen. Während eines Herstellverfahrens derartiger Halbleiterspeicheranordnungen werden üblicherweise erste Elektroden über leitenden Verbindungen aufgebracht, wobei jeweils eine der leitenden Verbindungen eine der ersten Elektroden mit jeweils einem der Auswahltransistoren verbindet. Über der ersten Elektrode wird ein Speicherdielektrikum aufgebracht, auf welchem wiederum eine zweite Elektrode aufgebracht wird, so daß die erste und die zweite Elektrode sowie das dazwischenliegende Speicherdielektrikum einen Speicherkondensator bilden, der mit einem der Auswahltransistoren leitend verbunden ist.

Eine Verwendung neuartiger ferroelektrischer Materialien als Speichendielektrikum der Speicherkondensatoren ermöglicht eine Herstellung von Halbleiterspeichern, die ihre in Form von elektrischer Ladung gespeicherte Information nach Wegfall einer Versorgungsspannung nicht verlieren bzw. deren Speicherinhalte nicht in regelmäßigen Abständen aufgrund auftretender Leckströme aufgefrischt werden müssen.

Kritisch bei der Verwendung der meisten der bisher bekannten derartigen ferroelektrischen Materialien ist deren Verarbeitung innerhalb eines Halbleiterprozesses. Eine Abscheidung der meisten derartigen ferroelektrischen Materialien findet bei hohen Temperaturen in einer sauerstoffhaltigen Atmosphäre statt. Die Verwendung derartiger ferroelektrischer Materialien in dem oben beschriebenen Verfahren, bei dem das Speicherdielektrikum über der ersten Elektrode aufgebracht wird, welche sich wiederum über einer leitenden Verbindung zu einem der Auswahltransistoren befindet, hat eine Oxidation der leitenden Verbindung zur Folge, da Sauerstoff während der Abscheidung der ferroelektrischen Materialien durch die erste Elektrode hindurch in Richtung der leitenden Verbindung difundiert und diese oxidiert. Eine Oxidation der leitenden Verbindung bedeutet eine Unterbrechung der elektrischen Verbindung zwischen Speicherkondensator und Auswahltransistor einer Speicherzelle, so daß diese nicht mehr funktionsfähig ist.

Lösungsansätze zur Vermeidung der Oxidation der leitenden Verbindung während des Abscheidens eines ferroelektrischen Speicherdielektrikums sehen vor, Barrierenschichten zwischen der leitenden Verbindung und der ersten Elektrode aufzubringen, wobei die Barrierenschichten elektrisch leitfähig aber widerstandsfähig gegen Oxidation und das Hindurchdifundieren von Sauerstoff sein müssen. Nachteilig bei der Verwendung von Barrierenschichten ist die schwierige Suche nach geeigneten Materialien, die sowohl elektrisch leitfähig als auch sauerstoffundurchlässig und widerstandsfähig gegen Oxidation sind und die in geeigneter Weise auf die leitenden Verbindungen aufgebracht werden können.

Ein Verfahren zur Herstellung einer intergrierten Halbleiterspeicheranordnung mit einem ferroelektrischen Speicherdielektrikum ohne die Verwendung von Barrierenschichten ist in der US 5,439,840 beschrieben. Bei diesem beschriebenen Verfahren werden die ersten Elektroden, das Speicherdielektrikum und die zweite Elektrode in Abscheidungsprozessen über einer Isolationsschicht aufgebracht, die sich über Auswahltransistoren befindet. Nachfolgend werden Kontaktlöcher durch die zweite Elektrode, das Speicherdielektrikum, die erste Elektrode und die Isolationsschicht zu den Auswahltransistoren erzeugt, durch welche eine Kontaktierung der zweiten Elektrode mit dem Auswahltransistor erfolgen kann. Nachteilig ist hierbei insbesondere das aufwendige Aufbringen einer weiteren Isolationsschicht in dem Kontaktloch, um die erste Elektrode elektrisch von der zweiten Elektrode zu isolieren.

Die Druckschrift US 5,436,477 betrifft einen DRAM (Dynamic Random Access Memory) mit einem Stapelkondensator, der oberhalb der Substratoberfläche angeordnet ist. Die Druckschrift US 5,313,089 betrifft ebenfalls eine DRAM Anordnung mit einem Stapelkondensator.

Der Erfindung liegt die Aufgabe zugrunde, ein Verfahren zur Herstellung einer integrierten Halbleiterspeicheranordnung zur Verfügung zu stellen, bei dem ferroelektrische Materialien zur Herstellung der Speicherdielektrika der herzustellenden Speicherkondensatoren verwendet werden können und bei dem auf die Verwendung von Barrierenschichten zwischen leitender Verbindung und erster Elektrode verzichtet werden kann, so daß sich insbesondere oben genannte Nachteile nicht ergeben, sowie eine nach dem Verfahren hergestellte Halbleiterspeicheranordnung anzugeben.

Diese Aufgabe wird gemäß Anspruch 1 durch ein Verfahren zur Herstellung einer integrierten Halbleiterspeicheranordnung gelöst, das folgende Verfahrensschritte aufweist:
- Bereitstellen einer Anordnung aus Auswahltransistoren, die eine Isolationsschicht aufweist, in der sich Kontaktlöcher zu Source-Gebieten der Auswahltransistoren befinden, wobei sich erste Kontaktplugs in den Kontaktlöchern befinden;
- Aufbringen mindestens einer ersten Elektrode auf die Oberfläche der Isolationsschicht, wobei die erste Elektrode Aussparungen derart aufweist, daß eine Oberfläche der ersten Kontaktplugs sowie an die Kontaktlöcher angrenzende Bereiche der Oberfläche der Isolationsschicht freiliegen;
- Abscheiden einer Dielektrikumsschicht;
- Abscheiden einer zweiten Schicht aus Elektrodenmaterial;
- Strukturieren der zweiten Schicht aus Elektrodenmaterial zur Herstellung von zweiten Elektroden;
- Freilegen der ersten Kontaktplugs;
- Herstellen von zweiten Kontaktplugs über den freigelegten ersten Kontaktplugs derart, daß jeweils eine der zweiten Elektroden mit jeweils einem der ersten Kontaktplugs elektrisch leitend verbunden ist.

Die Aufgabe wird ferner gelöst durch ein Verfahren gemäß Anspruch 2 sowie durch eine integrierte Halbleiteranordnung gemäß Anspruch 8.

Bei dem erfindungsgemäßen Verfahren zur Herstellung einer integrierten Halbleiterspeicheranordnung erfolgt die Herstellung einer leitenden Verbindung zwischen einer der beiden Elektroden, in diesem Fall der zweiten Elektrode, und dem Auswahtransistor erst nachdem das Speicherdielektrikum abgeschieden wurde. Die Herstellung der leitenden Verbindung zwischen.dem Source-Gebiet des Auswahltransistors und der zweiten Elektrode erfolgt bei der vorliegenden Erfindung über den ersten und den zweiten Kontaktplug. Eine Oxidation einer in der ersten Hauptfläche gelegenen Oberfläche der ersten Kontaktplugs beim Abscheiden der Dielektrikumsschicht wird in Kauf genommen, da in einem der nächsten Verfahrensschritte beim Freilegen der ersten Kontaktplugs, vor dem Herstellen der zweiten Kontaktplugs, oxidierte Bereiche der Oberflächen der ersten Kontaktplugs entfernt werden können. Das Verfahren ist geeignet für die Verwendung beliebiger Dielektrika als Speicherdielektrika von Speicherkondensatoren in integrierten Halbleiterspeicheranordnungen. Es ist insbesondere geeignet für die Verwendung ferroelektrischer Materialien als Speicherdielektrika, da bei diesem Verfahren oben genannte Probleme, wie die Oxidation der leitenden Verbindung zu den Auswahltransistoren während der Abscheidung des Speicherdielektrikums, nicht auftreten können, da die leitende Verbindung erst nach Abscheidung des Speicherdielektrikums hergestellt wird. Das Verfahren ist weiterhin mit bisher bekannten Methoden zur Herstellung von integrierten Halbleiterspeicheranordnungen leicht durchführbar.

Die der Erfindung zugrundeliegende Aufgabe wird ferner durch ein Verfahren gemäß Anspruch 2 gelöst. Dieses Verfahren unterscheidet sich von dem Verfahren gemäß Anspruch 1 dadurch, daß zuerst die oxidierten Oberflächen der ersten Kontaktfüllungen freigelegt werden, bevor die zweite Elektrodenschicht abgeschieden und strukturiert wird. Die zweite Elektrodenschicht kommt daher bei ihrer Abscheidung direkt mit den ersten Kontaktfüllungen in Kontakt, wodurch eine leitende Verbindung hergestellt wird; die Fertigung zweiter Kontaktfüllungen erübrigt sich.

Weiterbildungen der Erfindung sind Gegenstand der Unteransprüche.

Für das Herstellen der ersten Elekroden über der ersten Hauptfläche der Isolationsschicht sind verschiedene Verfahren denkbar. Eine Ausführungsform der Erfindung sieht vor, die ersten Elektroden durch Abscheiden einer ersten Schicht aus Elektrodenmaterial in Richtung der ersten Hauptfläche herzustellen wobei die erste Schicht anschließend von in der ersten Hauptfläche liegenden Oberflächen der ersten Kontaktplugs und von an die Oberflächen angrenzenden Bereichen der ersten Hauptfläche, vorzugsweise durch anisotropes Ätzen entfernt wird, so daß Aussparungen der ersten Schicht entstehen, die in der Fläche größer sind als die Oberflächen der ersten Kontaktplugs. Die auf den freiliegenden Bereichen der ersten Hauptfläche befindlichen Teile der Dielektrikumsschicht, die in einem der nächsten Verfahrensschritte abgeschieden wird, trennen bei der nach dem Verfahren hergestellten Halbleiterspeicheranordnung die mit der zweiten Elektrode verbundenen zweiten Kontaktplugs von der ersten Elektrode.

Eine weitere Ausführungsform der Erfindung sieht vor, die erste Schicht aus Elektrodenmaterial auf einer Hilfsschicht abzuscheiden, die derart strukturiert ist, daß sie Aussparungen über den ersten Kontaktplugs aufweist, so daß die Oberflächen der ersten Kontaktplugs sowie daran angrenzende Bereiche der ersten Hauptfläche freiliegen. Nach dem Abscheiden der ersten Schicht aus Elektrodenmaterial wird die erste Schicht von den Oberflächen der ersten Kontaktplugs und angrenzenden Bereichen der ersten Hauptfläche entfernt. Das Aufbringen der ersten Elektroden über der Hilfsschicht bringt eine Erhöhung der Fläche der ersten Elektrode mit sich, da sich die erste Elektrode zusätzlich zu den parallel zur ersten Hauptfläche verlaufenden Flächen der Hilfsschicht auch über Seitenflächen der Aussparungen der Hilfsschicht erstreckt. Eine Erhöhung der Fläche der ersten Elektrode bedeutet eine Erhöhung der Kondensatorfläche der entstehenden Speicherkondensatoren und somit der Speicherkapazität.

Eine weitere Ausführungsform der Erfindung sieht vor, die Oberflächen der ersten Kontaktplugs bereits nach dem Abscheiden der Dielektrikumsschicht, und vor dem Abscheiden der zweiten Schicht aus Elektrodenmaterial freizulegen und eventuell oxidierte Bereiche der ersten Kontaktplugs zu entfernen. Dieses Verfahren bietet den Vorteil, daß in einem der nächsten Verfahrensschritte die zweite Schicht aus Elektrodenmaterial direkt über den ersten Kontaktplugs aufgebracht werden kann, so daß auf die Herstellung eines zweiten Kontaktplugs verzichtet werden kann. Dieses Verfahren ist insbesondere dann geeignet, wenn nach der Abscheidung der Dielektrikumsschicht keine weiteren Verfahrensschritte auftreten, bei dener eine Oxidation der ersten Kontaktplugs erfolgen könnte.

Die ferroelektrischen Eigenschaften der meisten der bisher bekannter ferroelektrischen Materialien, welche nach einer Ausführungsform der Erfindung als Speicherdielektrikum in Frage kommen sind temperaturabhängig. Diese ferroelektrischen Materialien verhalten sich unterhalb einer für sie charakteristischen Temperatur ferroelektrisch, während sie sich oberhalb dieser charakteristischen Temperatur paraelektrisch verhalten, wobei die Dielektrizitätskonstante im paraelektrischen Zustand wesentlich höher ist als die Dielektrizitätskonstanten bisher verwendeter Speicherdielektrika . Die Temperatur, unterhalb derer sich ferroelektrische Eigenschaften einstellen, ist bei einigen ferroelektrischen Materialien sehr niedrig, so daß aus technischer Sicht eine Verwendung dieser ferroelektrischen Materialien nur im paraelektrischen Zustand in Frage kommt, wobei deren Dielektrizitätskonstante im paraelektrischen Zustand jeweils über 10, vorzugsweise über 100 beträgt.

Eine Ausführungsform der Erfindung sieht vor, Materialien als Speicherdielektrika zu verwenden, deren Dielektrizitätskonstante jeweils größer als 10 ist, wobei derartige Materialien beispielsweise oben genannte ferroelektrische Materialien sein können, die oberhalb der für sie charakteristischen Temperatur verwendet werden.

Eine Ausführungsform der Erfindung sieht vor, oxidische Dielektrika als Speicherdielektrika zu verwenden. Zur Klasse dieser Substanzen gehören beispielsweise SBTN SrBi₂(Ta₁₋ₓNbₓ)₂O₉, PZT Pb(Zr,Ti)O₃, BST (Ba, Sr)TiO₃ oder ST SrTiO₃. Die Formel Pb(Zr,Ti)O₃ steht für PbZrₓTi₁₋ₓO₃. Der Anteil an Zr und Ti bei diesem Substrat kann variieren, wobei das Verhältnis aus Zr und Ti das Temperaturverhalten dieses Dielektrikums maßgeblich bestimmt, d. h. die Temperatur bestimmt, unterhalb deren das Substrat ferroelektrische Eigenschaften bzw. oberhalb derer das Substrat paraelektrische Eigenschaften aufweist. Die Formel (Ba, Sr)TiO₃ steht für BaₓSr₁₋ₓTiO₃, wobei bei diesem Substrat das Temperaturverhalten über das Verhältnis von Ba zu Sr maßgeblich bestimmt werden kann. Die Liste der genannten Substanzen ist keineswegs vollständig. Die Auswahl einer der Substanzen als Speicherdielektrikum hängt maßgeblich von Verarbeitungsfaktoren während des Herstellverfahrens aber auch von Faktoren während des Einsatzes der Halbleiterspeicheranordnung, beispielsweise der Umgebungstemperatur ab.

Halbleiterspeicheranordnungen, die nach dem erfindungsgemäßen Verfahrer hergestellt werden, sind Gegenstand der Unteransprüche 9 bis 12.

Die Erfindung wird nachfolgend im Zusammenhang mit Ausführungsbeispielen anhand von Figuren nächer erläutert. Es zeigen:
- Fig. 1: Einzelne Schnittbilder durch eine Halbleiterspeicheranordnung während verschiedener Verfahrensschritte zur Herstellung einer Halbleitespeicheranordnung,
- Fig. 2: Eine Draufsicht auf einen Ausschnitt einer Halbleiterspeicheranordnung während eines Verfahrensschrittes,
- Fig. 3: Eine Draufsicht auf einen Ausschnitt einer Halbleiterspeicheranordnung während eines weiteren Verfahrensschrittes,
- Fig. 4: Einzelne Schnittbilder durch eine Halbleiterspeicheranordnung während verschiedener Verfahrensschritte eines zweiten Verfahrens zur Herstellung einer Halbleiterspeicheranordnung,
- Fig. 5: Einzelne Schnittbilder durch eine Halbleiterspeicheranordnung während verschiedener Verfahrensschritte eines weiteren Verfahrens zur Herstellung einer Halbleiterspeicheranordnung,
- Fig. **6**: Einzelne Schnittbilder durch eine Halbleiterspeicheranordnung während verschiedener Verfahrensschritte eines vierten Verfahrens zur Herstellung einer Halbleiterspeicheranordnung,

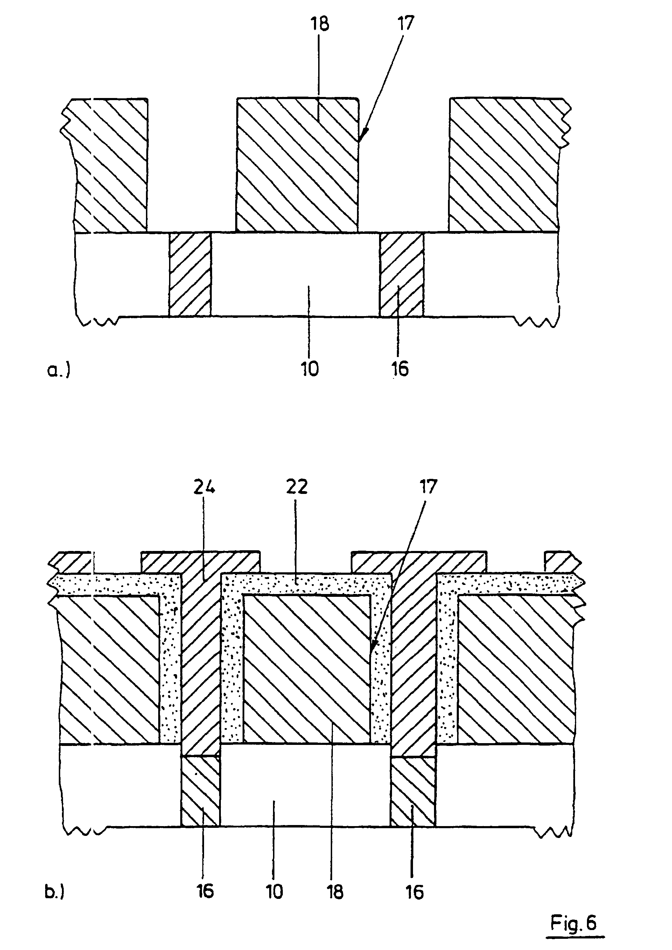

- Fig. 6: Schnittbild durch eine nach einem erfindungsgemäßen Verfahren hergestellte Halbleiterspeicheranordnung,

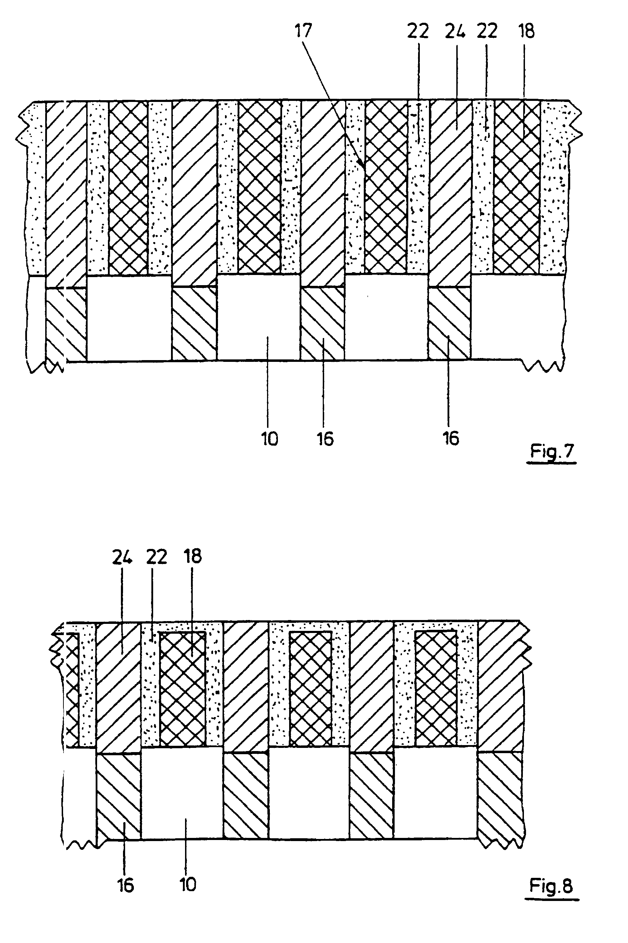

- **Fig. 7**: Schnittbild durch eine nach einem erfindungsgemäßen Verfahren hergestellte Halbleiterspeicheranordnung.

In den nachfolgenden Figuren bezeichnen, sofern nicht anders angegeben, gleiche Bezugszeichen gleiche Teile mit gleicher Bedeutung.

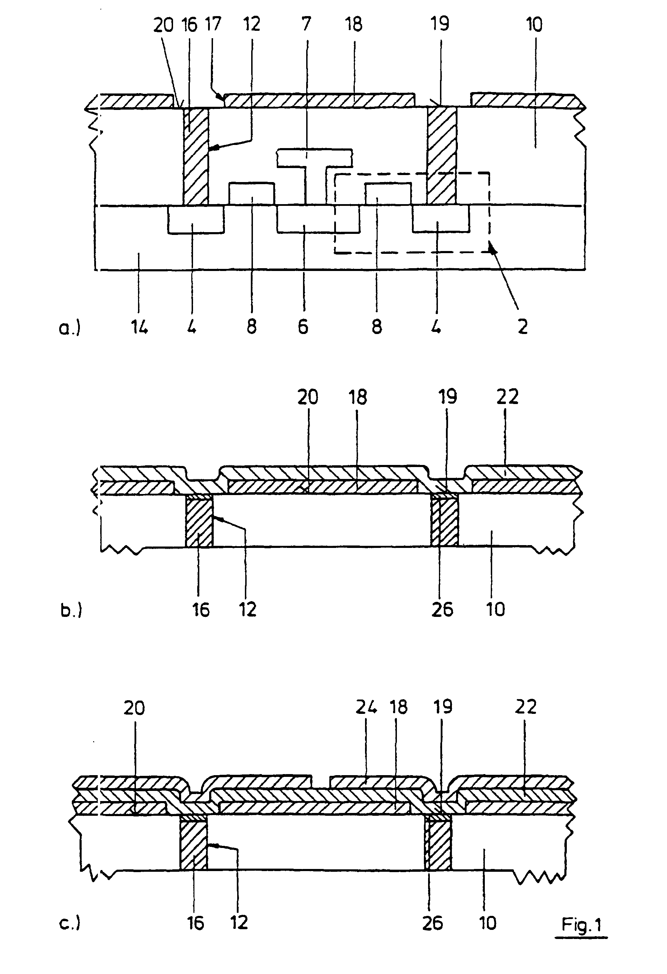

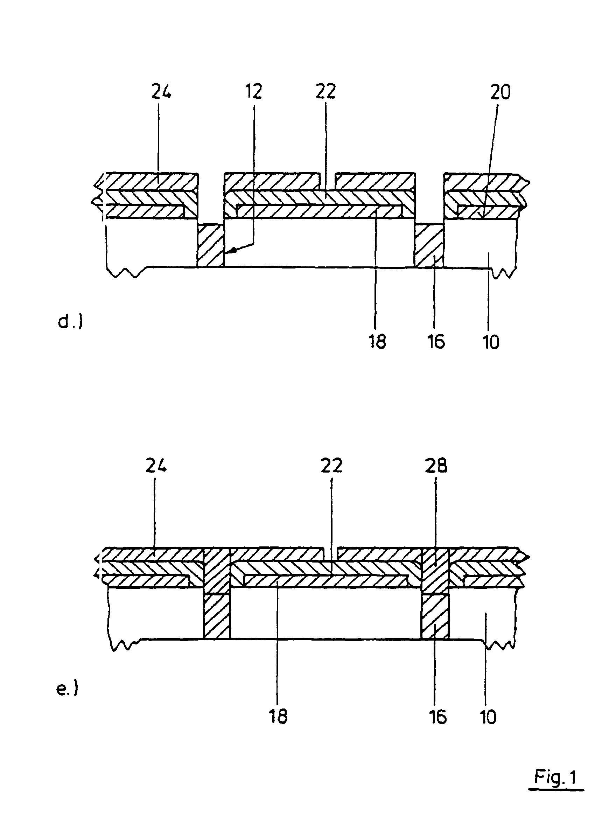

In Fig. 1 ist ein Verfahren nach der Erfindung zur Herstellung einer integrierten Halbleiterspeicheranordnung anhand mehrerer in den Figuren 1a bis 1e dargestellter Verfahrensschritte erläutert.

Fig. 1a zeigt einen Querschnitt durch einen Ausschnitt einer Anordnung aus Auswahltransistoren 2, die einen Halbleiterkörper 14 aufweist, über dem eine Isolationsschicht 10 angeordnet ist. Zwei in der Figur dargestellte Auswahltransistoren 2 besitzen ein gemeinsames Drain-Gebiet 6 sowie jeweils ein Source-Gebiet 4 und ein Gate 8. Die Source- und Drain-Gebiete 4, 6 befinden sich in dem Halbleiterkörper 14, während das Gate 8 in der darüberliegenden Isolationsschicht 10 angeordnet ist und von dem Halbleiterkörper 14 durch einen Teil der Isolationsschicht 10 getrennt ist. Das in der Isolationsschicht 10 angeordnete Gate 8 kann beispielsweise aus Polysilizium bestehen, während die Source- und Drain-Gebiete 4, 6 komplementär zum Leitungstyp des Halbleiterkörpers 14 dotierte Bereiche des Halbleiterkörpers 14 sein können. Eine Bitleitung 7 ist mit dem gemeinsamen Drain-Gebiet 6 der beiden Auswahltransistoren 2 verbunden. In der Isolationsschicht 10 befindet sich über den Source-Gebieten 4 jeweils ein Kontaktloch 12, in dem sich ein erster Kontaktplug 16 befindet, der mit jeweils einem der Source-Gebiete 4 elektrisch leitend verbunden ist. In einer ersten Hauptfläche 20 der Isolationsschicht 10 ist eine erste Elektrode 18 angeordnet, die Aussparungen 17 aufweist, so daß Oberflächen 19 der ersten Kontaktplugs sowie an die Oberflächen 19 angrenzende Bereiche der ersten Hauptfläche 20 nach oben hin frei liegen. Zwischen der ersten Elektrode 18 und der Isolationsschicht 10 kann eine Schicht aus Haftvermittler, beispielsweise Titandioxid TiO₂, aufgebracht sein, um ein besseres Anhaften der ersten Elektrode 18 an der Isolationsschicht 10 zu erreichen.

Aus Gründen der Übersichtlichkeit wird in den folgenden Figuren auf die Darstellung des Halbleiterkörpers 14 sowie der Auswahltransistoren 2 und der Bitleitung 7 verzichtet. Auf die Darstellung weiterer Verdrahtungsebenen der Halbleiterspeicheranordnung wird in allen Figuren verzichtet.

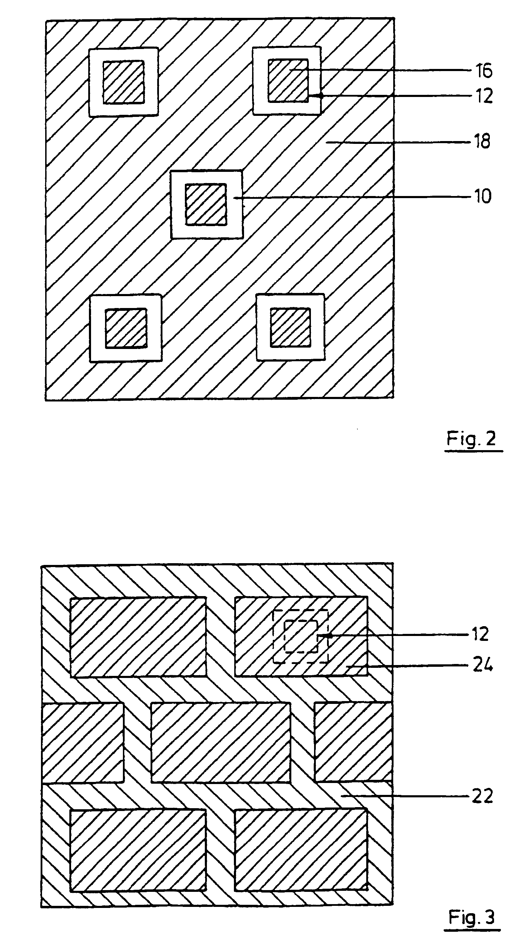

In Fig. 2 ist die in Fig. 1a dargestellte Anordnung in Draufsicht dargestellt. Der in Fig. 2 dargestellte Ausschnitt zeigt die erste Elektrode 18, die im vorliegenden Fall fünf rechteckige Aussparungen aufweist, so daß die Kontaktplugs 16 sowie angrenzende Bereiche der ersten Hauptfläche 20 der Isolationsschicht 10 nach oben hin frei liegen.

Fig 1b zeigt die in Fig. 1a dargestellte Anordnung nach einem weiteren Verfahrensschritt, bei dem eine Dielektrikumsschicht 22 in Richtung der ersten Hauptfläche 20 abgeschieden wurde, so daß die erste Elektrode 18, die Oberflächen 19 der ersten Kontaktplugs 16 und in den Aussparungen 17 der ersten Elektrode 18 freiliegende Bereiche der ersten Hauptfläche 20 überdeckt sind. In Fig. 1b sind weiterhin oxidierte Bereiche 26 der ersten Kontaktplugs 16 dargestellt, die während des Abscheidens der Dielektrikumsschicht 22 bei hohen Temperaturen in einer sauerstoffhaltigen Atmosphäre entstehen können.

Fig. 1c zeigt die in Fig. 1b dargestellte Anordnung nach weiteren Verfahrensschritten, in denen zweite Elektroden 24 über der Dielektrikumsschicht 22 hergestellt wurden. Die Herstellung der zweiten Elektroden 24 kann beispielsweise durch Abscheiden einer zweiten Schicht aus Elektrodenmaterial in Richtung der ersten Hauptfläche 20 erfolgen, wobei die zweite Schicht anschließend beispielsweise durch anisotopes Ätzen in Abschnitte der Fläche der zweiten Elektroden 24 unterteilt wird. Die erste Elektrode 18, die Dielektrikumsschicht 22 und die zweiten Elektroden 24 bilden Speicherkondenstoren der Halbleiterspeicheranordnung, wobei die erste Elektrode 18 in dem dargestellten Ausführungsbeispiel einer Anzahl Speicherkondensatoren gemeinsam ist.

Fig. 3 zeigt die in Fig. 1c dargestellte Anordnung in Draufsicht. Dargestellt sind die zweiten Elektroden 24 sowie die zwischen den zweiten Elektroden 24 freiliegende Dielektrikumsschicht 22. Ferner sind in Fig. 3 eines der Kontaktlöcher 12 und eine der Aussparungen 17 der ersten Elektrode 18 unter einer der zweiten Elektroden 24 gestrichelt angedeutet.

Fig. 1d zeigt die in Fig. 1c dargestellte Anordnung nach einem weiteren Verfahrensschritt, bei dem die ersten Kontaktplugs 16 nach oben hin durch teilweises Entfernen der über den Kontaktplugs 16 befindlichen Dielektrikumsschicht 22 und durch teilweises Entfernen der zweiten Elektroden 24 nach oben hin freigelegt wurden. Während des Verfahrensschrittes zum Freilegen der ersten Kontaktplugs 16 wurden auch die oxidierten Bereiche 26 der Kontaktplugs 16 entfernt. Das Freilegen der ersten Kontaktplugs 16 kann beispielsweise durch anisotropes Ätzen der Dielektrikumsschicht 22 und der ersten Elektroden 24 erfolgen.

In Fig. 1e ist die in Fig. 1d dargestellte Anordnung nach einem weiteren Verfahrensschritt dargestellt, in dem zweite Kontaktplugs 28 über den freigelegten ersten Kontaktplugs 16 hergestellt wurden, so daß jeweils einer der ersten Kontaktplugs 16 über einen der zweiten Kontaktplugs 28 mit jeweils einer der zweiten Elektroden 24 elektrisch leitend verbunden ist. Als Material für die beiden Kontaktplugs 16, 28 und die Elektroden 18, 24 kommen eine Vielzahl elektrisch leitfähiger Materialien in Betracht. Insbesondere Platin ist sowohl als Elektrodenmaterial als auch als Material für die zweiten Kontaktplugs 28 gut geeignet. Ein weiteres geeignetes Material ist beispielsweise Polysilizium.

Wie in Fig. 1d und 1e dargestellt, bleibt beim Freilegen der ersten Kontaktplugs 16 ein Teil der Dielektrikumsschicht 22 in der ersten Hauptfläche 20 um die Kontaktlöcher 12 erhalten. Dieser Teil der Dielektrikumsschicht 22 trennt die hergestellten zweiten Kontaktplugs 28 von der ersten Elektrode 18.

Treten nach dem Abscheiden der Dielektrikumsschicht 22 keine weiteren Prozesse auf, die zu einer Oxidation der ersten Kontaktplugs 16 führen können, so ist es denkbar die ersten Kontaktplugs 16 bereits nach dem Abscheiden der Dielektrikumsschicht 22 freizulegen und daraufhin die zweiten Elektroden 24 herzustellen, so daß auf eine Herstellung der zweiten Kontaktplugs 28 in einem eigenen Verfahrensschritt verzichtet werden kann.

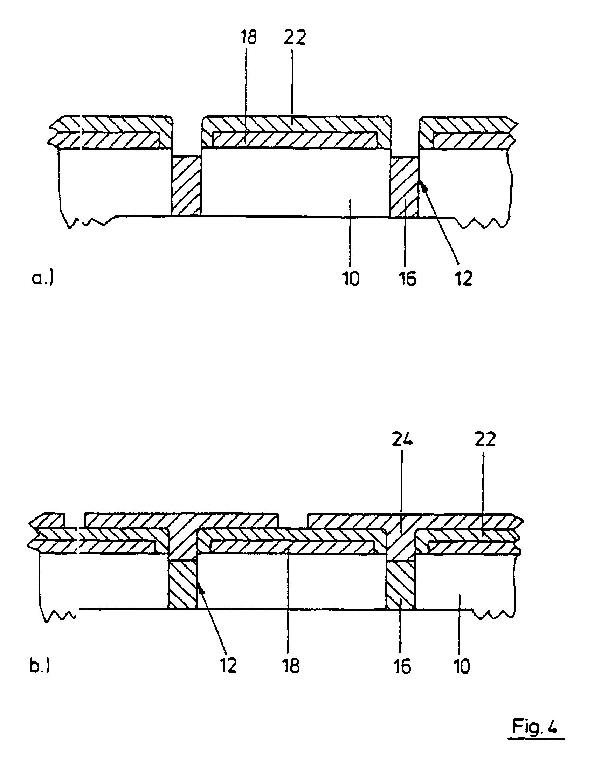

Dieses modifizierte Verfahren ist in Fig. 4 anhand der Figuren 4a und 4b dargestellt.

Fig. 4a zeigt die in Fig 1b dargestellte Anordnung, bei der die Dielektrikumsschicht 22 über der ersten Elektrode 18 und den ersten Kontaktplugs 16, sowie über freigelegten Bereichen der ersten Hauptfläche 20 abgeschieden wurde, nach einem weiteren Verfahrensschritt, bei dem die ersten Kontaktplugs 16 nach oben hin freigelegt wurden. Das Freilegen der ersten Kontaktplugs 16 kann beispielsweise durch anisotropes Ätzen der über den ersten Kontaktplugs 16 befindlichen Dielektrikumsschicht 22 erfolgen. Bei diesem Vorgang bleibt auf der ersten Hauptfläche 20 im Anschluß an die Kontaktlöcher 12 ein Teil der Dielektrikumsschicht 22 zurück.

Fig. 4b zeigt die in Fig. 4a dargestellte Anordnung nach einem weiteren Verfahrensschritt, in dem zweite Elektroden 24 über der Dielektrikumsschicht 22 hergestellt wurden, die in direktem Kontakt mit den ersten Kontaktplugs 16 stehen. Auf eine nachfolgende Herstellung von zweiten Kontaktplugs 28 (vgl. hierzu Fig. 1) kann verzichtet werden, die zweiten Kontaktplugs 28 sind integraler Bestandteil der zweiten Elektroden 24. Die Herstellung der zweiten Elektroden 24 kann beispielsweise durch Abscheidung einer zweiten Schicht aus Elektrodenmaterial in Richtung der ersten Hauptfläche 20 erfolgen, wobei die zweite Schicht anschließend in Abschnitte unterteilt wird, deren Größe der Größe der zweiten Elektroden 24 entspricht. Eine Draufsicht auf die in Fig. 4b dargestellte Anordnung entspricht der in Fig. 3 dargestellten Draufsicht auf eine Halbleiterspeicheranordnung.

Ein Verfahren nach der Erfindung sieht vor, vor dem Abscheiden der ersten Schicht aus Elektrodenmaterial eine Hilfsschicht 30 über der ersten Hauptfläche 20 der Anordnung aus Auswahltransistoren 2 aufzubringen.

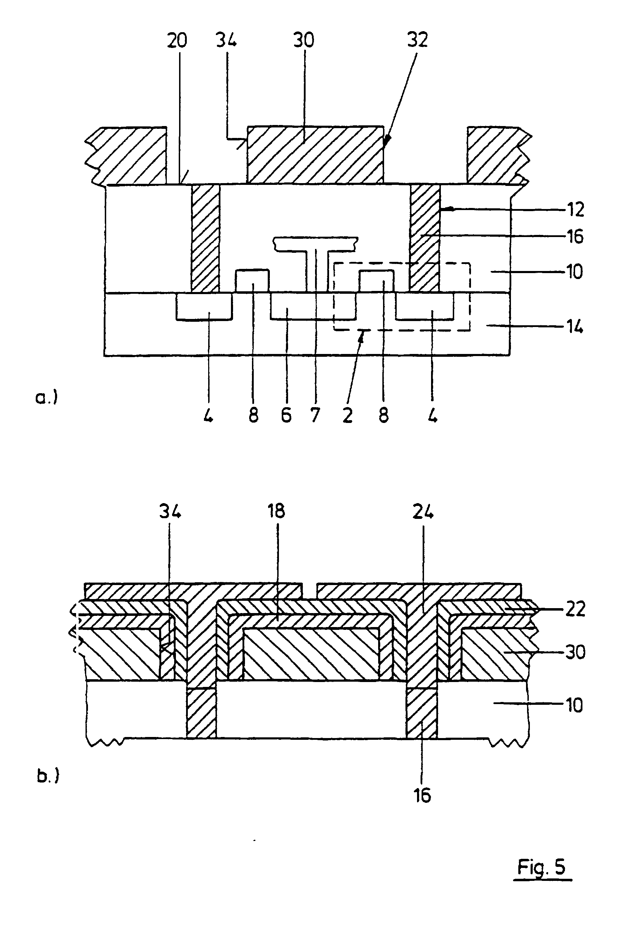

Fig. 5a zeigt eine Anordnung aus Auswahltransistoren 2 im Querschnitt, auf deren erste Hauptfläche 20 eine Hilfsschicht 30 aufgebracht wurde, die Aussparungen 32 aufweist. Die Aussparungen 32 sind derart gestaltet, daß die ersten Kontaktplugs 16, sowie an die Kontaktlöcher 12 angrenzende Bereiche der ersten Hauptfläche 20 nach oben hin frei liegen.

Die nachfolgenden Verfahrensschritte, das Herstellen der ersten Elektrode 18, das Abscheiden der Dielektrikumsschicht 22, das Herstellen der zweiten Elektroden 24, das Freilegen der ersten Kontaktplugs 16 und gegebenenfalls das Herstellen der zweiten Kontaktplugs 28 verlaufen analog wie beschrieben.

In Fig. 5b ist ein Ausschnitt einer nach diesem Verfahren hergestellten Halbleiterspeicheranordnung im Querschnitt dargestellt, wobei bei der Herstellung der dargestellten Halbleiterspeicheranordnung die ersten Kontaktplugs 16 im Anschluß an die Abscheidung der Dielektrikumsschicht 22 freigelegt wurden, so daß die zweiten Elektroden 24 direkt mit den ersten Kontaktplugs 16 leitend verbunden werden konnten. Aus Fig. 5b wird deutlich, daß die Kondensatorfläche von aus erster Elektrode 18, Dielektrikumsschicht 22 und zweiter Elektrode 24 gebildeten Speicherkondensatoren bei Verwendung einer Hilfsschicht 30 größer ist, als die Kondensatorfläche von Speicherkondensatoren die ohne Verwendung einer Hilfsschicht hergestellt wurden, wie in Fig. 1c oder Fig. 4b dargestellt. Die Erhöhung der Kondensatorfläche resultiert aus einer um Seitenflächen 34 der Hilfsschicht 30 vergrößerten Fläche, die zur Herstellung der Speicherkondensatoren zur Verfügung steht.

Auf die Hilfsschicht 30 zur Vergrößerung der Kondensatorfläche kann bei Aufbringen einer hohen ersten Elektrode 18 auf der ersten Hauptfläche 20 verzichtet werden, wie in Figur 6a dargestellt. Nach Abscheiden des Speicherdielektrikums 22 und dem Herstellen der zweiten Elektroden 24 ergibt sich die in Figur 6b im Querschnitt dargestellte Halbleiterspeicheranordnung. Der Speicherkondensator wird durch die erste und zweite Elektrode 18,24, sowie durch das dazwischen befindliche Speicherdielektrikum 22 gebildet.

Fig. 7 zeigt die in Fig. 6 dargestellte Halbleiterspeicheranordnung bei der in dem Schritt zur Strukturierung der zweiten Schicht aus Elektrodenmaterial zur Herstellung von zweiten Elektroden, die zweite Schicht aus Elektrodenmaterial sowie das Speicherdielektrikum 22 vollständig von parallel zur ersten Hauptfläche 20 verlaufenden Bereichen der ersten Elektrode 18 entfernt wurde. Die zweiten Elektroden befinden sich vollständig innerhalb der Aussparungen 17 der ersten Elektrode 18 und werden durch das Speicherdielektrikum 22 von dieser getrennt. Die ersten Elektroden 18 liegen nach oben hin frei. Im Gegensatz zu dem in Fig. 8 dargestellten Ausführungsbeispiel, bei dem eine Schicht des Speicherdielektrikums 22 über den ersten Elektoden 18 zur Isolierung erhalten ist. Die Rückätzung der zweiten Elektroden 24 kann beispielsweise durch eine Gasphasenätzung erfolgen.

## Patentansprüche

1. Verfahren zur Herstellung einer integrierten Halbleiterspeicheranordnung, das folgende Verfahrensschritte in der angegebenen Reihenfolge aufweist:
- Bereitstellen einer Anordnung aus Auswahltransistoren (2), die eine Isolationsschicht (10) aufweist, in der sich Kontaktlöcher (12) zu Source-Gebieten (4) der Auswahltransistoren (2) befinden, wobei sich erste Kontaktplugs (16) in den Kontaktlöchern befinden;
- Aufbringen mindestens einer ersten Elektrode (18) auf die Oberfläche (20) der Isolationsschicht (10), wobei die erste Elektrode (18) Aussparungen (17) derart aufweist, daß Oberflächen (19) der ersten Kontaktplugs (16) sowie an die Kontaktlöcher (12) angrenzende Bereiche der Oberfläche (20) der Isolationsschicht (10) freiliegen;
- Abscheiden einer Dielektrikumsschicht (22);
- Abscheiden einer zweiten Schicht aus Elektrodenmaterial;
- Strukturieren der zweiten Schicht aus Elektrodenmaterial zur Herstellung von zweiten Elektroden (24);
- Freilegen der ersten Kontaktplugs (16);
- Herstellen von zweiten Kontaktplugs (28) über den freigelegten ersten Kontaktplugs derart, daß jeweils eine der zweiten Elektroden (24) mit jeweils einem der ersten Kontaktplugs (16) elektrisch leitend verbunden ist.

2. Verfahren zur Herstellung einer integrierten Halbleiter-Halbleiterspeicheranordnung, das folgende Verfahrensschritte in der angegebenen Reihenfolge aufweist:
- Bereitstellen einer Anordnung aus Auswahltransistoren (2), die eine Isolationsschicht (10) aufweist, in der sich Kontaktlöcher (12) zu Source-Gebieten (4) der Auswahltransistoren (2) befinden, wobei sich erste Kontaktplugs (16) in den Kontaktlöchern befinden;
- Aufbringen mindestens einer ersten Elektrode (18) auf die Oberfläche (20) der isolationsschicht (10), wobei die erste Elektrode (18) Aussparungen (17) derart aufweist, daß Oberflächen (19) der ersten Kontaktplugs (16) sowie an die Kontaktlöcher (12) angrenzende Bereiche der Oberfläche(20) der Isolationsschicht (10) freiliegen;
- Abscheiden einer Dielektrikumsschicht (22);
- Freilegen der ersten Kontaktplugs (16);
- Abscheiden einer zweiten Schicht aus Elektrodenmaterial;
- Strukturieren der zweiten Schicht aus Elektrodenmaterial zur Herstellung von zweiten Elektroden (24).

3. Verfahren nach Anspruch 1 oder 2, **dadurch gekennzeichnet, daß** die erste Elektrode (18) durch Abscheiden einer ersten Schicht aus Elektrodenmaterial auf die Oberfläche (20) der Isolationsschicht (10) erzeugt wird, wobei die erste Schicht von Oberflächen (19) der Kontaktplugs (16) und von an die Kontaktlöcher (12) angrenzenden Bereichen der der Oberfläche(20) der Isolationsschicht (10) entfernt wird.

4. Verfahren nach einem der vorangehenden Ansprüche, **dadurch gekennzeichnet, daß** vor dem Abscheiden der ersten Sch:.cht aus Elektrodenmaterial eine strukturierte Hilfsschicht (30) auf der Oberfläche (20) der Isolationssch:.cht (10) aufgebracht wird, wobei die Hilfsschicht (30) Aussparungen (32) aufweist, so daß die Oberflächen (19) der ersten Kontaktplugs (16) und an die Kontaktlöcher (12) angrenzende Bereiche der Oberfläche (20) der Isolationsschicht (10) frei liegen.

5. Verfahren nach einem der vorangehenden Ansprüche, **dadurch gekennzeichnet, daß** die Dielektrikumsschicht (22) aus einem Material besteht, das ferroelektrische Eigenschaften aufweist.

6. Verfahren nach einem der vorangehenden Ansprüche, **dadurch gekennzeichnet, daß** die Dielektrikumsschicht (22) aus einem Material besteht, das eine Dielektrizitätskonstante größer als 10 besitzt.

7. Verfahren nach einem der vorangehenden Ansprüche, **dadurch gekennzeichnet, daß** das Speicherdielektrikum ein oxidisches Dielektrikum, insbesondere SBTN SrBi₂ (Ta₁₋ₓNbₓ)₂O₉, PZT Pb(Zr,Ti)O₃, BST (Ba, Sr)TiO₃ oder ST SrTiO₃ ist .

8. Integrierte Halbleiterspeicheranordnung bestehend aus einer Anzahl gleichartiger Speicherzellen, die jeweils folgende Merkmale aufweisen:
8.1. einen Auswahltransistor (2 über dem sich eine Isolationsschicht (10) befindet;
8.2. ein Kontaktloch (12) in der Isolationsschicht (10) über einem Source-Gebiet (4) des Auswahltransistors (2), wobei sich ein erster Kontaktplug (16) in dem Kontaktloch (12) befindet und mit dem Source-Gebiet (4) leitend verbunden ist;
8.3. eine erste Elektrode (18), die über der Oberfläche (20) der Isolationsschicht (10) angeordnet ist und die über den Oberflächen (19) der ersten Kontaktplugs (16) und über an die Oberflächen (19) angrenzenden Bereichen der Oberfläche (20) der Isolationsschicht ausgespart ist;
8.4. eine zweite Elektrode (24), die durch eine Dielektrikumsschicht (22), die in Aussparungen (17) der ersten Elektrode (18) an die Oberflächen (19) der ersten Kontaktplugs (16) angrenzende Bereiche der Oberfläche (20) der Isolationsschicht (10) überdeckt, von der ersten Elektrode (18) getrennt ist;
8.5. einen zweiten Kontaktplug (28), der sich durch die erste Elektrode (18) erstreckt, der von der ersten Elektrode (18) durch einen Teil der Dielektrikumsschicht (22) getrennt ist und der eine zweite Elektrode (24) mit dem ersten Kontaktplug (16) elektrisch leitend verbindet.

9. Halbleiterspeicheranordnung nach Anspruch 8, **dadurch gekennzeichnet, daß** eine strukturierte Hilfsschicht (30) auf der Oberfläche (20) der Isolationsschicht (10) angeordnet ist, wobei die Hilfsschicht (30) eine Aussparung (32) über dem Kontaktloch (12) und angrenzenden Bereichen der Oberfläche (20) aufweist, und daß die erste Elektrode (18) auf der Hilfsschicht (30) angeordnet ist.

10. Halbleiterspeicheranordnung nach Anspruch 8 oder 9, **dadurch gekennzeichnet, daß** der zweite Kontaktplug (28) integraler Bestandteil der zweiten Elektrode (24) ist.

11. Halbleiterspeicheranordnung nach einem der Ansprüche 8 bis 10, **dadurch gekennzeichnet, daß** die Dielektrikumsschicht (22) aus einem Material besteht, das ferroelektrische Eigenschaften aufweist.

12. Halbleiterspeicheranordnung nach einem der Ansprüche 8 bis 11, **dadurch gekennzeichnet, daß** die Dielektrikumsschicht (22) aus einem Material besteht, das eine Die-. lektrizitätskonstante größer 10 besitzt.

13. Halbleiterspeicheranordnung nach einem der Ansprüche 8 bis 12, **dadurch gekennzeichnet, daß** das Speicherdielektrikum ein oxidisches Dielektrikum, insbesondere SBTN SrBi₂ (Ta₁₋ₓNbₓ)₂O₉, PZT (Pb, Zr)TiO₃, BST (Ba, Sr)TiO₃ oder ST SrTiO₃ ist.

## Claims

1. Process for producing an integrated semiconductor memory arrangement, having the following process steps in the order specified:
- provision of an arrangement of selection transistors (2) which has an insulation layer, (10) containing contact holes (12) through to source regions (4) of the selection transistors (2), first contact plugs (16) being located in the contact holes;
- application of at least one first electrode (18) to the surface (20) of the insulation layer (10), the first electrode (18) having cutouts (17) such that surfaces (19) of the first contact plugs (16) as well as regions of the surface (20) of the insulation layer (10) which are adjacent to the contact holes (12) are exposed;
- deposition of a dielectric layer (22);
- deposition of a second layer of electrode material;
- patterning of the second layer of electrode material in order to produce second electrodes (24) ;
- exposing the first contact plugs (16);
- production of second contact plugs (28) above the exposed first contact plugs such that a respective one of the second electrodes (24) is connected to a respective one of the first contact plugs (16) in an electrically conductive manner.

2. Process for producing an integrated semiconductor memory arrangement, having the following process steps in the order specified:
- provision of an arrangement of selection transistors (2) which has an insulation layer (10) containing contact holes (12) through to source regions (4) of the selection transistors (2), first contact plugs (16) being located in the contact holes;
- application of at least one first electrode (18) to the surface (20) of the insulation layer (10), the first electrode (18) having cutouts (17) such that surfaces (19) of the first contact plugs (16) as well as regions of the surface (20) of the insulation layer (10) which are adjacent to the contact holes (12) are exposed;
- deposition of a dielectric layer (22);
- exposing the first contact plugs (16);
- deposition of a second layer of electrode material;
- patterning of the second layer of electrode material in order to produce second electrodes (24) .

3. Process according to Claim 1 or 2, **characterized in that** the first electrode (18) is produced by depositing a first layer of electrode material onto the surface (20) of the insulation layer (10), the first layer being removed from surfaces (19) of the contact plugs (16) and from regions of the surface (20) of the insulation layer (10) which are adjacent to the contact holes (12).

4. Process according to one of the preceding claims, **characterized in that**, before the first layer of electrode material is deposited, a patterned auxiliary layer (30) is applied to the surface (20) of the insulation layer (10), the auxiliary layer (30) having cutouts (32), so that the surfaces (19) of the first contact plugs (16) and regions of the surface (20) of the insulation layer (10) which are adjacent to the contact holes (12) are exposed.

5. Process according to one of the preceding claims, **characterized in that** the dielectric layer (22) is made of a material which has ferroelectric properties.

6. Process according to one of the preceding claims, **characterized in that** the dielectric layer (22) is made of a material which has a dielectric constant higher than 10.

7. Process according to one of the preceding claims, **characterized in that** the storage dielectric is an oxide-containing dielectric, in particular SBTN SrBi₂ (Ta₁₋ₓNbₓ)₂O₉, PZT Pb(Zr, Ti)O₃, BST (Ba, Sr)TiO₃ or ST SrTiO₃.

8. Integrated semiconductor memory arrangement comprising a number of identical memory cells which each have the following features:
8.1 a selection transistor (2) with an insulation layer (10) above it;
8.2 a contact hole (12) in the insulation layer (10) above a source region (4) of the selection transistor (2), a first contact plug (16) being located in the contact hole (12) and being conductively connected to the source region (4);
8.3 a first electrode (18), which is arranged above the surface (20) of the insulation layer (10) and which has cutouts above the surfaces (19) of the first contact plugs (16) and above regions of the surface (20) of the insulation layer which are adjacent to the surfaces (19);
8.4 a second electrode (24), which is isolated from the first electrode (18) by a dielectric layer (22) which, in cutouts (17) of the first electrode (18), covers regions of the surface (20) of the insulation layer (10) which are adjacent to the surfaces (19) of the first contact plugs (16);
8.5 a second contact plug (28), which extends through the first electrode (18) and which is isolated from the first electrode (18) by part of the dielectric layer (22) and which connects a second electrode (24) to the first contact plug (16) in an electrically conductive manner.

9. Semiconductor memory arrangement according to Claim 8, **characterized in that** a patterned auxiliary layer (30) is arranged on the surface (20) of the insulation layer (10), the auxiliary layer (30) having a cutout (32) above the contact hole (12) and adjacent regions of the surface (20), and **in that** the first electrode (18) is arranged on the auxiliary layer (30).

10. Semiconductor memory arrangement according to Claim 8 or 9, **characterized in that** the second contact plug (28) is an integral part of the second electrode (24).

11. semiconductor memory arrangement according to one of Claims 8 to 10, **characterized in that** the dielectric layer (22) is made of a material which has ferroelectric properties.

12. Semiconductor memory arrangement according to one of Claims 8 to 11, **characterized in that** the dielectric layer (22) is made of a material which has a dielectric constant higher than 10.

13. Semiconductor memory arrangement according to one of Claims 8 to 12, **characterized in that** the storage dielectric is an oxide-containing dielectric, in particular SBTN SrBi₂ (Ta₁₋ₓNbₓ)₂O₉, PZT (Pb, Zr)TiO₃, BST (Ba, Sr)TiO₃ or ST SrTiO₃.

## Revendications

1. Procédé de production d'un dispositif de mémoire à semi-conducteur intégré, qui comporte les stades de procédé suivants dans l'ordre indiqué :
- mise à disposition d'un dispositif constitué de transistors (2) de sélection, qui a une couche (10) d'isolement, dans laquelle se trouvent des trous (12) de contact allant aux zones (4) de source des transistors (2) de sélection, des premiers plugs (16) de contact se trouvant dans les trous de contact ;
- dépôt d'au moins une première électrode (18) à la surface (20) de la couche (10) d'isolement, la première électrode (18) comportant des évidements (17), de façon à mettre à nu des surfaces (19) des premiers plugs (16) de contact ainsi que des parties de la surface (20) de la couche (10) d'isolement, qui sont voisines des trous (12) de contact ;
- dépôt d'une couche (22) de diélectrique ;
- dépôt d'une deuxième couche en matériau d'électrode ;
- structuration de la deuxième couche en matériau d'électrode pour produire des deuxièmes électrodes (24) ;
- mise à nu des premiers plugs (16) de contact ;
- production de deuxièmes plugs (28) de contact au-dessus des premiers plugs de contact mis à nu, de façon à ce que respectivement l'une des deuxièmes électrodes (24) soit reliée d'une manière conductrice de l'électricité à respectivement l'un des premiers plugs (16) de contact.

2. Procédé de production d'un dispositif de mémoire à semi-conducteur intégré qui comporte les stades de procédé suivants dans l'ordre indiqué:
- mise à disposition d'un dispositif constitué de transistors (2) de sélection, qui a une couche (10) d'isolement, dans laquelle se trouvent des trous (12) de contact allant aux zones (4) de source des transistors (2) de sélection, des premiers plugs (16) de contact se trouvant dans les trous de contact ;
- dépôt d'au moins une première électrode (18) à la surface (20) de la couche (10) d'isolement, la première électrode (18) comportant des évidements (17), de façon à mettre à nu des surfaces (19) des premiers plugs (16) de contact ainsi que des parties de la surface (20) de la couche (10) d'isolement, qui sont voisines des trous (12) de contact ;
- dépôt d'une couche (22) de diélectrique ;
- mise à nu des premiers plugs (16) de contact ;
- dépôt d'une deuxième couche de matériau d'électrode ;
- structuration de la deuxième couche en matériau d'électrode pour la production de deuxièmes électrodes (24).

3. Procédé suivant la revendication 1 ou 2, **caractérisé en ce que** l'on produit la première électrode (18) par dépôt d'une première couche en matériau d'électrode à la surface (20) de la couche (10) d'isolement, la première couche de surface (19) des plugs (16) de contact et de parties de la surface (20) de la couche (10) d'isolement qui sont voisines des trous (12) de contact étant éliminée.

4. Procédé suivant l'une des revendications précédentes, **caractérisé en ce qu'**avant le dépôt de la première couche en matériau d'électrode, on dépose une couche (30) auxiliaire structurée à la surface (20) de la couche (10) d'isolement, la couche (30) auxiliaire comportant des évidements (32), de manière à mettre à nu les surfaces (19) des premiers plugs (16) de contact et des parties de la surface (20) de la couche (10) d'isolement, qui sont voisines des trous (12) de contact.

5. Procédé suivant l'une des revendications précédentes, **caractérisé en ce que** la couche (22) de diélectrique est en un matériau qui a des propriétés ferroélectriques.

6. Procédé suivant l'une des revendications précédentes, **caractérisé en ce que** la couche (22) de diélectrique est en un matériau qui a une corstante diélectrique supérieure à 10.

7. Procédé suivant l'une des revendications précédentes, **caractérisé en ce que** le diélectrique de mémoire est un diélectrique oxydé, notamment SBTN SrBi₂(Ta₁₋ₓNbₓ)₂O₉, PZT Pb(Zr, Ti)O₃, BST (Ba, Sr)TiO₃ ou ST SrTiO₃.

8. Dispositif de mémoire à semi-conducteur intégré constitué d'un certain nombre de cellules de mémoire de même type, qui ont respectivement les caractéristiques suivantes :
8.1. un transistor (2) de sélection, sur lequel se trouve une couche (10) d'isolement ;
8.2. un trou (12) de contact dans la couche (10) d'isolement au-dessus d'une zone (4) de source de transistor (2) de sélection, un premier plug (16) de contact se trouvant dans le trou (12) de contact et étant relié d'une manière conductrice à la zone (4) de source ;
,8.3. une première électrode (18) qui est disposée au-dessus de la surface (20) de la couche (10) d'isolement et qui est évidée au-dessus des surfaces (19) des premiers plugs (16) de contact et au-dessus des parties de la surface (20) de la couche d'isolement qui sont voisines des surfaces (19) ;
8.4. une deuxième électrode (24) qui est séparée de la première électrode (18) par une couche (22) de diélectrique qui recouvre dans des évidements (17) de la première électrode (18) des parties de la surface (20) de la couche (10) d'isolement, qui sont voisines des surfaces (19) des premiers plugs (16) de contact ;
8.5. un deuxième plug (28) de contact qui s'étend à travers la première électrode (18), qui est séparé de la première électrode (18) par une partie de la couche (22) de diélectrique et qui relie d'une manière conductrice de l'électricité une deuxième électrode (24) au premier plug (16) de contact.

9. Dispositif de mémoire à semi-conducteur suivant la revendication 8, **caractérisé en ce qu'**une couche (30) auxiliaire structurée est disposée à la surface (20) de la couche (10) d'isolement, la couche (30) auxiliaire ayant un évidement (32) au-dessus du trou (12) de contact et de parties voisines de la surface (20), et **en ce que** la première électrode (18) est disposée sur la couche (30) auxiliaire.

10. Dispositif de mémoire à semi-conducteur suivant la revendication 8 ou 9, **caractérisé en ce que** le deuxième plug (28) de contact fait partie intégrante de la deuxième électrode (24).

11. Dispositif de mémoire à semi-conducteur suivant l'une des revendications 8 à 10, **caractérisé en ce que** la couche (22) de diélectrique est en un matériau qui a des propriétés ferroélectriques.

12. Dispositif de mémoire à semi-conducteur suivant l'une des revendications 8 à 11, **caractérisé en ce que** la couche (22) de diélectrique est en un matériau qui a une constante diélectrique supérieure à 10.

13. Dispositif de mémoire à semi-conducteur suivant l'une des revendications 8 à 12, **caractérisé en ce que** le diélectrique de mémoire est un diélectrique oxydé, notamment SBTN SrBi₂(Ta₁₋ₓNbₓ)₂O₉, PZT (Pb, Zr)TiO₃, BST (Ba Sr)TiO₃ ou ST SrTiO₃.
